# FASCICULE DE BREVET EUROPEEN

(11) **EP 2 884 547 B1**
(45) Date de publication et mention de la délivrance du brevet: **09.11.2016**
(21) Numéro de dépôt: 14197696.9
(22) Date de dépôt: 12.12.2014
(51) Int. Cl.: H01L 31/105, H01L 31/18, G02B 6/42, G02B 6/12

(54) **Procédé de fabrication d'un photo-détecteur.**
Verfahren zur Herstellung eines Fotodetektors
Method for manufacturing a photodetector

(30) Priorité: 13.12.2013 FR 1302934
(43) Date de publication de la demande: 17.06.2015
(73) Titulaire: Commissariat à l'Energie Atomique et aux Energies Alternatives, 75015 Paris (FR)
(72) Inventeur: Hartmann, Jean-Michel, 38420 Le Versoud (FR); Bogumilowicz, Yann, 38100 Grenoble (FR); Fedeli, Jean-Marc, 38120 Saint-Egrève (FR)
(74) Mandataire: Talbot, Alexandre

(56) Documents cités:
- US-A1- 2007 104 441
- US-A1- 2011 012 221
- US-A1- 2012 126 286
- REN S ET AL: "Thin Dielectric Spacer for the Monolithic Integration of Bulk Germanium or Germanium Quantum Wells With Silicon-on-Insulator Waveguides", IEEE PHOTONICS JOURNAL, IEEE, USA, vol. 3, no. 4, août 2011 (2011-08), pages 739-747, XP011485120, ISSN: 1943-0655, DOI: 10.1109/JPHOT.2011.2162644

## Description

### Domaine de l'Invention

L'invention est relative à un procédé de fabrication d'un photo-détecteur.

### Etat de la technique

De manière classique, les photo-détecteurs sont utilisés pour convertir un signal lumineux en un signal électrique. Le photo-détecteur comporte une zone de détection qui réalise la conversion des photons en électrons et une zone de traitement électrique qui collecte les électrons pour en faire un signal électrique pour d'autres circuits.

La demande de brevet US 2007/0104441 A1 décrit un dispositif optoélectronique comportant un guide d'onde couplé à un photodétecteur.

La publication de Ren et al « Thin Dielectric Spacer for the Monolithic Intégration of Bulk Germanium or Germanium Quantum Wells With Silicon-on-Insulator Waveguides, IEEE Photonics Journal Vol. 3, No. 4, p. 739 (2011) décrit un photo-détecteur particulier.

Un substrat de type silicium sur isolant est fourni et il comporte un support en silicium, une couche électriquement isolante et un second film en silicium. Le second film en silicium est gravé une première fois pour former un guide d'onde. Une seconde gravure est réalisée pour accéder au support en silicium.

Afin de réaliser une croissance épitaxiale de meilleure qualité, des espaceurs latéraux en oxyde de silicium sont formés sur les bords de la tranchée. De cette manière, la croissance sélective du germanium est réalisée exclusivement depuis le fond de la tranchée c'est-à-dire depuis le support en silicium.

La croissance du germanium est décomposée en un premier dépôt de germanium dopé P, un deuxième dépôt de germanium intrinsèque et un troisième dépôt de germanium dopé N. Cet enchainement d'étapes de croissance permet de former une diode de type PIN.

La partie intrinsèque de la diode fait face au guide d'onde.

On constate cependant que cette configuration n'est pas aussi efficace que prévue. On constate également que le procédé de fabrication est compliqué à mettre en oeuvre.

### Objet de l'invention

L'invention a pour objet de présenter un procédé de fabrication d'un photo-détecteur qui soit plus facile à mettre en oeuvre.

On tend à atteindre ce résultat au moyen d'un procédé comportant :
- fournir un substrat comportant :
   o une première portion munie successivement d'un premier film semi-conducteur, une couche électriquement isolante, un deuxième film semi-conducteur, une couche de protection,
   o une deuxième portion munie successivement du premier film semi-conducteur, la couche électriquement isolante, la couche de protection et dépourvue du deuxième film semi-conducteur,
   o une troisième portion munie du premier film semi-conducteur, et dépourvue du deuxième film semi-conducteur et de la couche de protection,
- graver partiellement le deuxième film semi-conducteur dans la première portion pour former une cavité,
- déposer au moins un troisième matériau semi-conducteur de manière à former une diode de type PIN dans la troisième portion à partir du premier film semi-conducteur et remplir la cavité de la première portion,
- déposer une couche de conversion configurée pour absorber un signal lumineux provenant du deuxième film semi-conducteur et convertir le signal lumineux en signal électrique, la couche de conversion connectant électriquement la diode PIN

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, en coupe transversale d'un empilement de couches utilisé pour la fabrication d'un photo-détecteur,
- les figures 2, 7, 11, 12 et 13 représentent, de manière schématique, en coupe transversale des étapes de réalisation d'un photo-détecteur,
- les figures 3 à 6 représentent, de manière schématique, en coupe transversale des étapes de réalisation d'un substrat particulier utilisable pour la fabrication d'un photo-détecteur,
- les figures 8 et 9 représentent, de manière schématique, en coupe transversale, des étapes de fabrication alternatives aux étapes 11 et 12,
- la figure 10 représente, de manière schématique, en vue de dessus le substrat lors de l'étape illustrée à la figure 9,
- la figure 14 représente, de manière schématique, en vue de dessus, le substrat lors de l'étape illustrée à la figure 13.

### Description détaillée

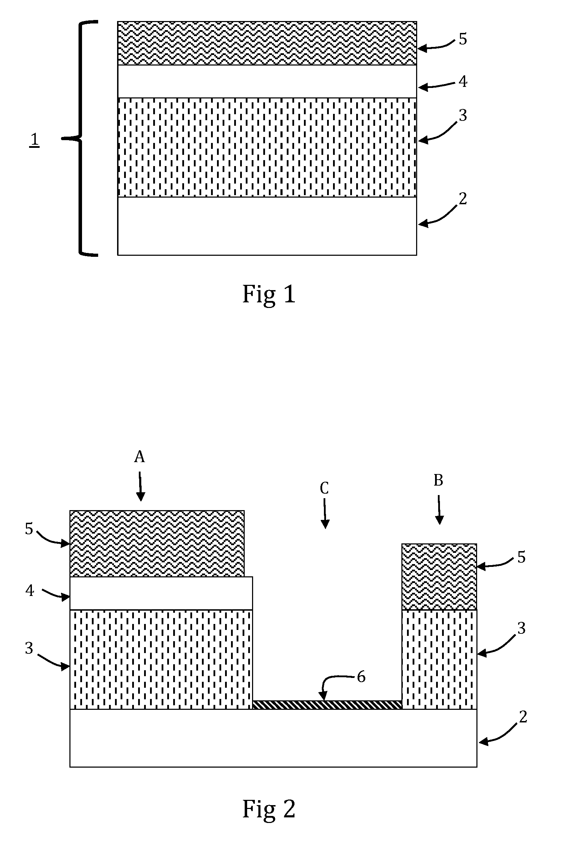

La figure 1 montre un substrat 1 comportant successivement un premier film semi-conducteur 2, une couche électriquement isolante 3, un deuxième film semi-conducteur 4 et une couche de protection 5. La quatre couches sont de natures différentes pour définir une interface entre deux couches consécutives.

Le premier film semi-conducteur 2 peut former le support du substrat ou il est déposé sur le support du substrat 1. Le premier film semi-conducteur 2 est avantageusement monocristallin afin de réaliser une diode de meilleure qualité. De manière préférentielle, le premier film semi-conducteur 2 comporte ou est relié à un circuit de traitement du signal électrique émis par le photo-détecteur. Le premier film semi-conducteur 2 est par exemple en silicium, mais il est également possible d'utiliser d'autres matériaux semi-conducteurs de valence IV ou alors d'autres matériaux adaptés.

La couche électriquement isolante 3 peut être formée par tout matériau adapté, par exemple par un oxyde, un nitrure, un mélange de ces derniers. A titre d'exemple, la couche électriquement isolante 3 peut être en oxyde de silicium ou en nitrure de silicium.

Le deuxième film semi-conducteur 4 est destiné à former un guide d'onde sur la couche électriquement isolante. Le deuxième film semi-conducteur 4 est avantageusement monocristallin afin de limiter l'atténuation du signal lumineux. De manière préférentielle, le deuxième film semi-conducteur 4 est relié à un générateur de signal lumineux (non représenté). Le deuxième film semi-conducteur 4 est par exemple en silicium, mais il est également possible d'utiliser d'autres matériaux semi-conducteurs de valence IV ou alors d'autres matériaux adaptés.

L'empilement présenté peut être réalisé simplement au moyen d'un substrat 1 de type semi-conducteur sur isolant et plus particulièrement de type silicium sur isolant.

La couche de protection 5 peut être formée par tout matériau adapté. La couche de protection 5 peut être formée par un matériau électriquement conducteur ou électriquement isolant. De manière préférentielle, un matériau électriquement isolant est utilisé. La couche de protection 5 peut être en oxyde, en nitrure, en matériau métallique ou en siliciure. De manière préférentielle, la couche de protection 5 est en oxyde de silicium ou en nitrure de silicium.

Les indices de réfraction de la couche de protection 5, du deuxième film semi-conducteur 4 et de la couche électriquement isolante 3 sont choisis de manière que le deuxième film semi-conducteur 4 forme un guide d'onde. De manière avantageuse, les matériaux sont choisis de manière que le deuxième film semi-conducteur 4 soit un guide d'onde pour un rayonnement ayant une longueur d'onde supérieure à 1100nm.

Comme illustré à la figure 2, le substrat 1 peut être décomposé en au moins trois portions différentes qui présentent des empilements différents. Les trois portions sont distinctes.

Dans une première portion A, l'empilement comporte successivement le premier film semi-conducteur 2, la couche électriquement isolante 4, le deuxième film semi-conducteur 3, la couche de protection 5.

Dans une deuxième portion B, l'empilement comporte successivement le premier film semi-conducteur 2, la couche électriquement isolante 3, la couche de protection 5. La deuxième portion B est dépourvue de deuxième film semi-conducteur 4. La deuxième portion B est distincte de la première portion A.

Dans une troisième portion C, l'empilement comporte le premier film semi-conducteur 2. La troisième portion C est dépourvue de couche de protection 5 et de deuxième film semi-conducteur 4. Le premier film semi-conducteur 2 peut être laissé libre ou il peut être recouvert par une couche de couverture 6. La couche de couverture 6 a pour objectif de protéger le premier film semi-conducteur 2 lors des étapes technologiques à venir et plus particulièrement lors des étapes de gravure. La couche de couverture 6 peut être formée par tout matériau adapté. La couche de couverture 6 peut être formée par la couche électriquement isolante 3 et avantageusement par une zone amincie de la couche électriquement isolante 3. En variante, un autre matériau peut être utilisé. La troisième portion C est distincte des première et deuxième portions A et B.

Le substrat 1 peut être réalisé de différentes manières. Un procédé simple et rapide à mettre en oeuvre est décrit.

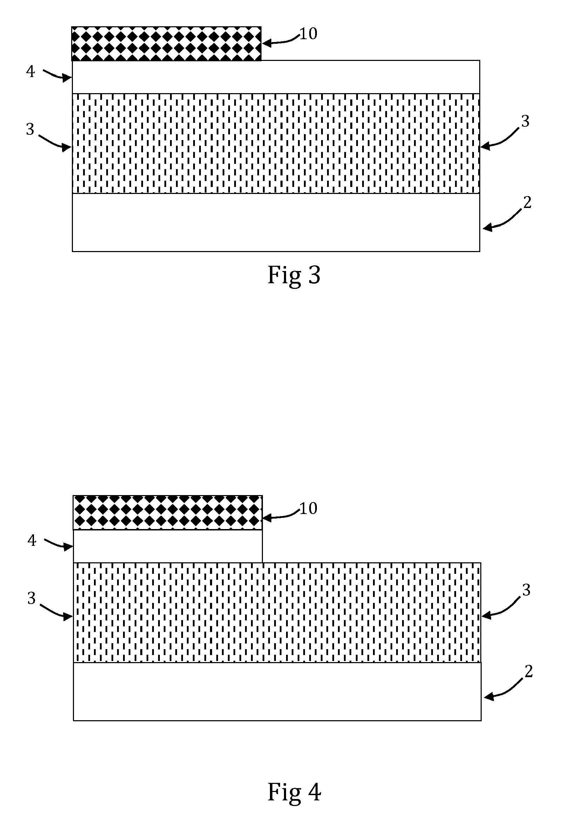

Un substrat 1 de type semi-conducteur du isolant est fourni (figure 1). Comme illustré à la figure 3, le substrat 1 est recouvert par un premier masque de gravure 10. Comme illustré à la figure 4, une première gravure est réalisée pour graver le deuxième film semi-conducteur 4 et définir la forme du guide d'onde. Le premier masque de gravure 10 permet de définir la forme ou sensiblement la forme de la première portion A.

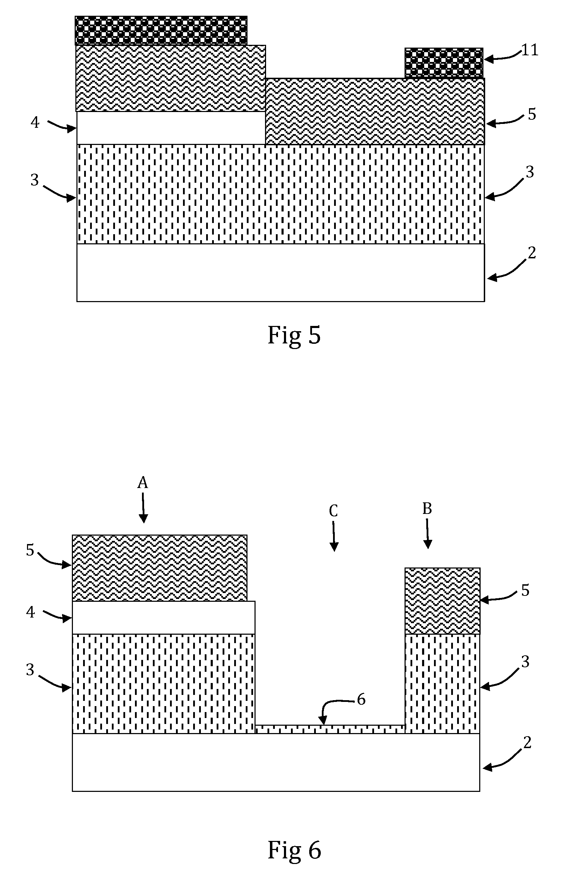

Comme illustré à la figure 5, la couche de protection 5 est déposée et un deuxième masque de gravure 11 est formé. Une deuxième gravure est réalisée pour définir la forme de la troisième portion C et éventuellement accéder au premier film semi-conducteur 2. De manière avantageuse, la couche de protection 5 vient recouvrir les faces latérales et la face supérieure du guide d'onde.

Le dessin de la zone à graver au moyen du deuxième masque de gravure 11 (la troisième portion C) vient avantageusement chevaucher le dessin de la zone à conserver du premier masque de gravure 10. Dans cette configuration illustrée à la figure 6, la gravure vient éliminer la couche de protection 5 au-dessus et à côté du guide d'onde qui devient alors accessible. Dans cette configuration, le guide d'onde s'arrête à l'interface entre la première portion A et la troisième portion C.

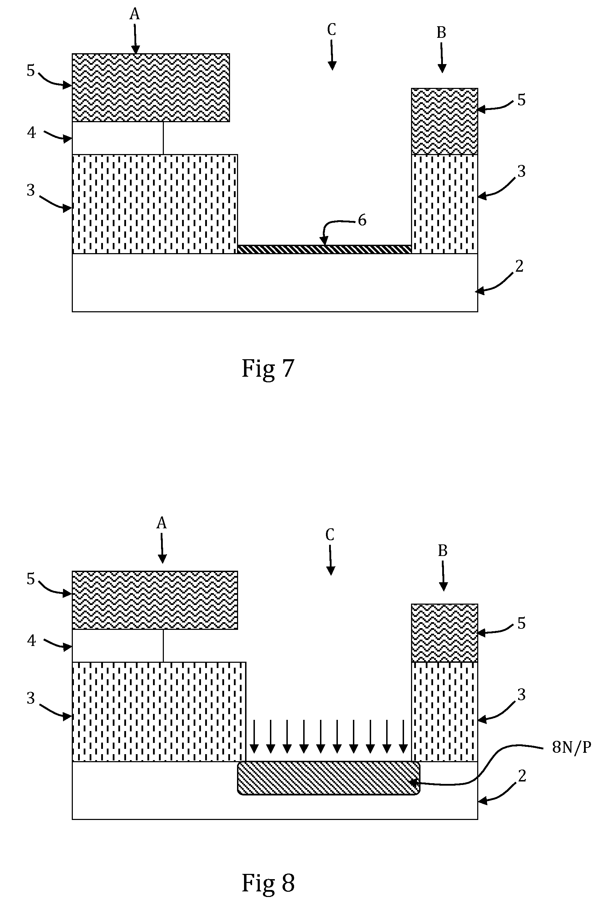

Comme illustré à la figure 7, une gravure est réalisée de manière à éliminer partiellement le deuxième film semi-conducteur 4 dans la première portion A. La gravure du deuxième film semi-conducteur 4 peut être réalisée par toute technique adaptée. De manière avantageuse, la gravure est sélective et elle comporte une composante isotrope.

A titre d'exemple, la gravure est réalisée par une gravure plasma. En variante, la gravure est réalisée au moyen d'acide chlorhydrique gazeux ce qui permet de graver des matériaux comme le silicium ou le silicium-germanium avec une bonne sélectivité de gravure par rapport à l'oxyde de silicium ou au nitrure de silicium.

Lorsque la couche de protection 5 recouvre les faces latérales et la face supérieure du guide d'onde, la gravure partielle permet de créer une cavité débouchante dans la couche de protection 5.

De manière avantageuse, la gravure du deuxième film semi-conducteur 4 est réalisé par de l'acide chlorhydrique gazeux ce qui permet d'éviter la formation de sous-produits de gravure sur le substrat tels que des polymères.

De manière avantageuse, l'étape de gravure du deuxième film semi-conducteur 4 est réalisée avec protection du premier film semi-conducteur 2 par la couche de couverture 6. Cependant, il est également envisageable d'avoir la gravure du deuxième film semi-conducteur 4 sans protection du premier film semi-conducteur 2. Dans ce deuxième cas de figure, il est intéressant d'avoir une vitesse de gravure plus importante pour le deuxième film semi-conducteur 4 que pour le premier film semi-conducteur 2.

Dans un mode de réalisation particulier, la face accessible du premier film semi-conducteur 2 est selon un plan (100) alors que la face accessible du deuxième film semi-conducteur 4 est selon un plan (110) ce qui permet d'avoir une différence de vitesse de gravure. En plus d'une différence de plans cristallins, il est également possible d'utiliser une différence de compositions chimiques pour obtenir une différence de vitesses de gravure.

Au moins un troisième matériau semi-conducteur 7 est déposé de manière à former une diode 8 de type PIN dans la troisième zone C. Le troisième matériau semi-conducteur 7 est déposé sur le premier film semi-conducteur 2 de manière à connecter électriquement la diode 8 de type PIN avec le premier film semi-conducteur 2.

La diode 8 de type PIN comporte successivement une première électrode 8P dopée de type P, une zone intrinsèque 8I et une deuxième électrode 8N de type N. Le sens de la diode PIN peut varier selon les modes de réalisation. Il est donc possible de former une diode PIN ou NIP si on observe l'ordre des couches depuis le premier film semi-conducteur 2.

Si le premier film semi-conducteur 2 est recouvert par la couche de couverture 6, une gravure additionnelle est réalisée pour libérer cette surface du film 2. A titre d'exemple, cette gravure peut être réalisée par de l'acide fluorhydrique dilué dans de l'eau si la couche de couverture 6 est à base d'oxyde de silicium.

La diode 8 de type PIN peut être formée de différentes manières. Dans un premier mode de réalisation illustré à la figure 8, une implantation est réalisée pour doper le premier film semi-conducteur 2 et former la première électrode 8. La première électrode peut être de type N ou P (8N/P). De manière avantageuse, la couche de couverture 6 est conservée pour réaliser l'implantation ionique dans le premier film semi-conducteur 2.

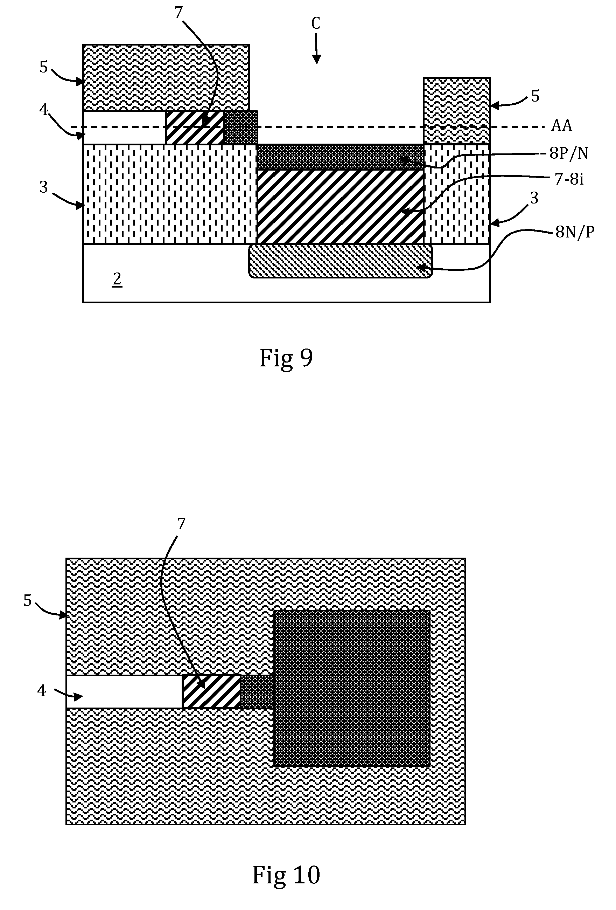

Comme illustré à la figure 9, le troisième matériau semi-conducteur 7 intrinsèque est ensuite déposé dans la troisième portion C. Dans une première variante, un matériau dopé est déposé pour former la deuxième électrode P ou N. Dans une autre variante, une implantation ionique est réalisée pour doper une partie du matériau 7 intrinsèque et former une zone dopée de type P ou N (8P/N). La figure 10 illustre en vue de dessus, dans une section prise selon la plan AA, l'agencement du guide d'onde par rapport à la cavité formée dans la couche de protection 5. Pour plus de facilité, il est fait abstraction de la couche de protection 5 au-dessus du guide d'onde.

Il est avantageux de doper le premier film semi-conducteur 2 si ce dernier n'est pas assez dopé pour former l'électrode N ou P ou si il est dopé de type opposé. Par exemple, si le premier film semi-conducteur 2 est dopé de type P, il est avantageux de réaliser une implantation ionique de dopants de type N pour former une première électrode 8N de type N.

Dans un deuxième mode de réalisation, le troisième matériau semi-conducteur 7 est déposé intrinsèque. Une implantation ionique est ensuite réalisée pour former une zone dopée 8N/P puis une autre implantation est réalisée pour former une autre zone dopée 8P/N.

Lors du dépôt du troisième matériau semi-conducteur 7, il y a également dépôt dans la première portion A depuis le deuxième film semi-conducteur 4.

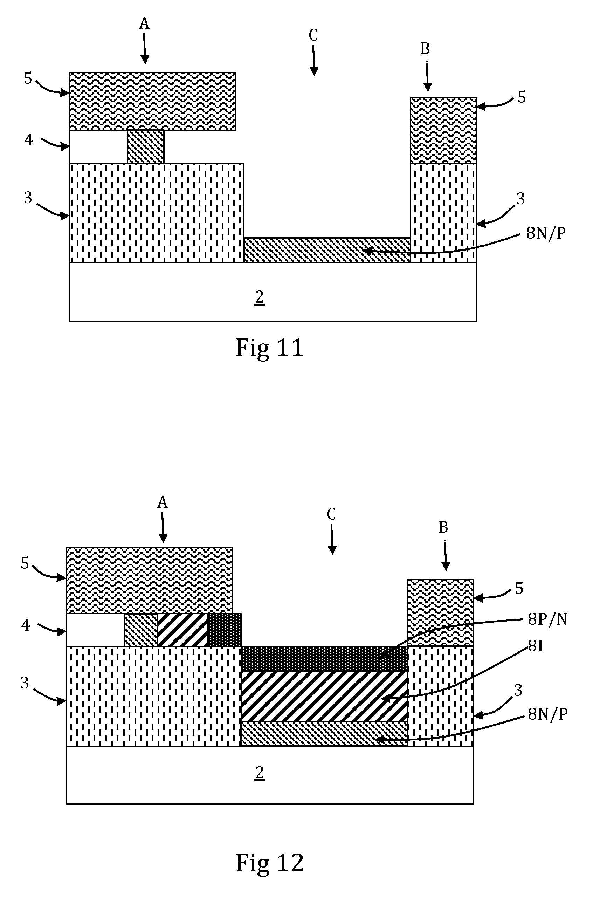

Dans une autre variante de réalisation illustrée aux figures 11 et 12, les couches formant la diode 8 sont déposées dopées les unes à la suite des autres. Il y alors dépôt d'une couche dopée N ou P, d'une couche intrinsèque et d'une couche dopée P ou N. L'empilement formé dans la troisième portion C de manière verticale se retrouve dans la première portion A de manière horizontale.

Les différentes couches déposées pour former la diode PIN sont visibles dans le guide d'onde. Il est donc avantageux de réaliser ces couches dans un matériau qui a une faible absorption du rayonnement lumineux afin de maximiser l'absorption des photons dans la zone de conversion. Avantageusement, les matériaux dans le guide d'onde ne sont pas dopés, ou faiblement dopées c'est-à-dire avec un dopage inférieur ou égal à 10.10¹⁸ at/cm³ voire 10.10¹⁷ at/cm³.

Dans un mode de réalisation préférentiel, les matériaux déposés pour former la diode 8 PIN sont les mêmes matériaux que ceux utilisés pour former le guide d'onde.

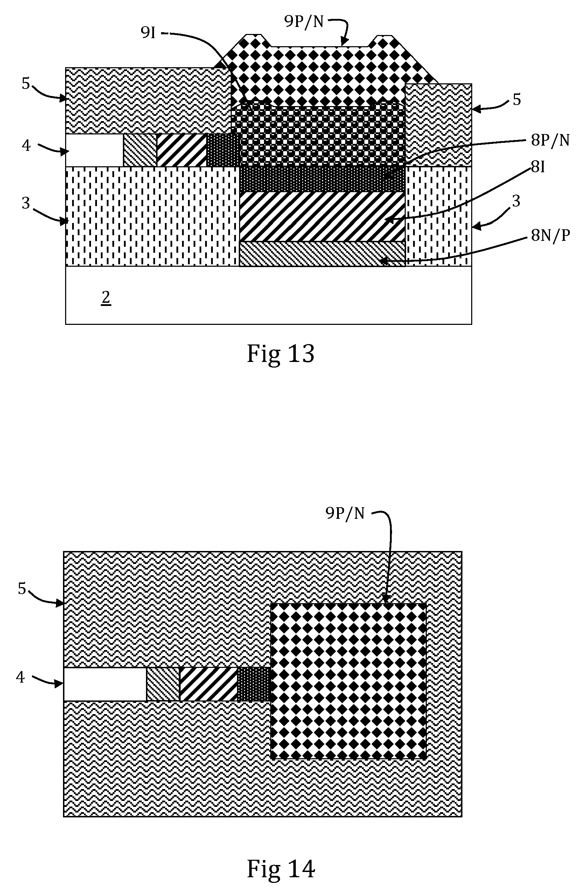

Comme illustré aux figures 13 et 14, après la formation de la diode 8 PIN, il est avantageux de former le matériau de conversion 9 qui va réaliser l'absorption des photons et leur conversion en charges électriques. Le matériau de conversion 9 est également appelé matériau de détection.

Le matériau de détection 9 est déposé dans la première portion A au-dessus de la diode 8 PIN et en contact électrique avec cette dernière de sorte que les charges crées transitent dans la diode PIN. Le matériau de conversion 9 est dopé en partie afin de prolonger le sens de propagation des porteurs de charge. Le matériau de conversion est dopé de manière à ce qu'il forme la diode 8 ou structure PIPIN ou NINIP. La zone dopée 9P/N du matériau de détection est du même type que la deuxième électrode 8P/N de la diode PIN, c'est-à-dire l'électrode la plus proche du guide d'onde.

Comme précédemment, le matériau de détection peut être déposé intrinsèque puis est dopé, par exemple, par implantation ionique. Il est également possible de déposer en premier lieu un matériau intrinsèque puis de déposer un matériau dopé qui formera l'électrode 9P/N.

Le matériau de détection 9 est également en contact direct avec le guide d'onde de manière à recevoir directement le signal lumineux pour le convertir en signal électrique. Cette connexion directe permet d'augmenter l'efficacité du photo-détecteur.

Le matériau de détection 9 est dans le prolongement du guide d'onde de manière à recevoir le maximum de signal lumineux. Dans un mode de réalisation avantageux, l'interface entre la diode 8 PIN et le matériau de conversion 9 est dans le même plan que l'interface entre la couche électriquement isolante 3 et le deuxième film semi-conducteur 4. De cette manière, la couche de conversion 9 est face au guide d'onde pour recevoir le maximum de signal lumineux afin de le transformer efficacement en charges électriques.

Dans une variante de réalisation plus avantageuse optiquement, l'interface entre la couche de conversion 9 et la diode 8 PIN est disposée sous l'interface entre la couche électriquement isolante 3 et le deuxième film semi-conducteur 4.

Dans une autre variante de réalisation moins avantageuse optiquement, l'interface entre la couche de conversion 9 et la diode 8 PIN est disposée au-dessus de l'interface entre la couche électriquement isolante 3 et le deuxième film semi-conducteur 4. De cette manière, la couche de conversion 9 absorbe partiellement le rayonnement lumineux et le matériau formant la diode 8 reçoit également une partie du rayonnement lumineux. Dans cette configuration, le rendement de conversion est moins bon.

Dans un mode de réalisation préférentiel, l'interface entre le guide d'onde et la couche de conversion 9 est dans le prolongement de la paroi latérale de la couche électriquement isolante 3 ou sensiblement dans le prolongement de la paroi latérale. Avantageusement, le guide d'onde est présent uniquement dans la première portion A et la couche de conversion 9 est présente uniquement dans la troisième portion C. Cependant, dans un autre mode de réalisation, la troisième portion peut être comprise entre deux premières portions A.

Si le matériau de conversion 9 empiète fortement dans la première portion A, l'absorption du rayonnement lumineux réalisée dans la première portion A et les charges électriques formées dans la première portion A arrivent difficilement à la diode 8 PIN. Cette architecture n'a pas un bon rendement de conversion.

Dans un mode de réalisation avantageux, la croissance des différentes couches est réalisée de manière épitaxiale afin de reproduire la maille cristalline de la surface de départ. De cette manière, la diode 8 de type PIN à la même structure cristalline que celle du premier film semi-conducteur 2. Il en est de même pour le matériau déposé et qui prolonge le guide d'onde gravé. Il est alors particulièrement avantageux d'utiliser des premier et deuxième films semi-conducteurs monocristallins.

Dans ce cas de figure, la couche de conversion 9 comporte une partie avec la même structure cristalline que celle du premier film semi-conducteur 2 et une partie avec la même structure cristalline que celle du deuxième film semi-conducteur 4 (même si les paramètres de maille ne sont pas identiques).

Il a été observé de manière inattendue que dans la couche de conversion 9, la coexistence de la maille cristalline provenant du guide d'onde avec la maille cristalline provenant du premier film semi-conducteur n'introduit pas des défauts cristallins limitant fortement la conversion du signal lumineux en signal électrique.

Pour former le photo-détecteur, il est préférable de réaliser une ou plusieurs étapes d'épitaxies sélectives afin de former la diode PIN et/ou le matériau de conversion. L'utilisation d'une croissance sélective permet d'avoir une croissance cristalline uniquement à partir du germe cristallin. Il n'y a donc pas ou presque pas de croissance depuis les surfaces en matériau amorphe. L'utilisation d'une croissance cristalline permet de former une diode 8 PIN avec des interfaces parallèles entre elles ce qui améliore son fonctionnement. Cela permet éventuellement de former une diode NINIP ou PIPIN complètement monocristalline ce qui est avantageux pour réduire le bruit électronique de la diode.

Il en est de même pour le guide d'onde qui est plus performant si l'on réduit les joints de grains et les défauts cristallins sur le trajet du signal lumineux.

Une croissance sélective peut être obtenue de différentes manières, par exemple au moyen d'une chimie employant des précurseurs chlorés qui est reconnue pour être intrinsèquement sélective.

En variante, il est également possible de réaliser une croissance sélective en alternant des phases de croissance non sélective et des phases de gravure sélective. Durant la phase de gravure sélective, le matériau monocristallin est moins gravé que le matériau poly-cristallin ou le matériau amorphe.

Lors de la formation de la couche de conversion 9, il est préférable de remplir complètement la cavité formée par la couche de protection 5. De cette manière, une quantité importante de matériau peut être utilisée pour convertir efficacement le signal lumineux en signal électrique. Afin d'assurer un remplissage optimal de la cavité, il est préférable de réaliser une croissance de la couche de conversion 9 qui déborde au-delà de la couche de protection 5. Cette précaution permet en générale d'assurer le remplissage de la cavité même si le matériau déposé a une croissance avec des facettes.

Par la suite, il est possible de localiser la couche de conversion dans la couche de protection au moyen d'une étape d'aplanissement. L'aplanissement peut être réalisé par toute technique adaptée, par exemple au moyen d'une étape de polissage mécano-chimique.

En comparaison de la structure divulguée dans la publication de Ren et al. citée plus haut, on constate que les performances sont améliorées car il n'y a pas d'espaceur latéral entre le guide d'onde et la zone de conversion 9. De cette manière, il n'y a pas génération d'une interface optique supplémentaire qui introduit des réflexions optiques qui diminuent la sensibilité de la diode.

On constate que le photo-détecteur peut avoir une diode PIN 8 formée dans un matériau différent du matériau de conversion 9 par exemple le germanium ce qui facilite la formation d'un dispositif à avalanche où des tensions importantes sont appliquées. Dans un mode de réalisation préférentiel, les électrodes N et P et la zone intrinsèque sont formées dans un matériau à base de silicium ce qui permet la formation d'un photo-détecteur à avalanche efficace.

On constate également que la gravure du guide d'onde avant de former la diode PIN permet d'éviter une croissance parasite de matériau dans la troisième portion C avec des facettes importantes. Ces facettes viennent gêner la croissance de la couche de conversion 9.

On constate encore que l'utilisation d'une deuxième portion B dépourvue de deuxième matériau semi-conducteur 4 permet de limiter le nombre de surfaces en matériau semi-conducteur qui débouchent dans la troisième portion C. Cette configuration permet de limiter les risques de génération de défauts cristallins lors des différentes étapes de croissance. Dans le mode de réalisation illustré, il n'y a qu'un seul guide d'onde qui débouche sur le matériau de conversion 9.

## Revendications

1. Procédé de fabrication d'un photo-détecteur, comportant les étapes suivantes :
- fournir un substrat (1) comportant :
o une première portion (A) munie successivement d'un premier film semi-conducteur (2), une couche électriquement isolante (3), un deuxième film semi-conducteur (4) destiné à former un guide d'onde, une couche de protection (5),
o une deuxième portion (B) munie successivement du premier film semi-conducteur (2), la couche électriquement isolante (3), la couche de protection (5) et dépourvue du deuxième film semi-conducteur (4),
∘ une troisième portion (C) munie du premier film semi-conducteur (2), et dépourvue du deuxième film semi-conducteur (4) et de la couche de protection (5), la troisième portion (C) étant disposée entre les première et deuxième portions (A, B),
- graver partiellement le deuxième film semi-conducteur (4) dans la première portion (A) pour former une cavité délimitée par la couche de protection (5) et la couche électriquement isolante (3),
- déposer au moins un troisième matériau semi-conducteur (7) de manière à former une diode (8) de type PIN ou NIP dans la troisième portion (C) à partir du premier film semi-conducteur (2) et remplir la cavité de la première portion pour prolonger le guide d'onde,
- déposer une couche de conversion (9) en contact avec le guide d'onde et configurée pour absorber un signal lumineux provenant du deuxième film semi-conducteur (4) et convertir le signal lumineux en signal électrique, la couche de conversion (9) connectant électriquement la diode (8) de type PIN ou NIP pour former une structure de type PIPIN ou NINIP.

2. Procédé de fabrication selon la revendication 1, **caractérisé en ce que** l'interface entre la couche de conversion (9) et l'électrode supérieure de la diode (8) PIN ou NIP est dans le même plan que l'interface entre la couche électriquement isolante (3) et le deuxième film semiconducteur (4).

3. Procédé de fabrication selon l'une des revendications 1 et 2, **caractérisé en ce qu'**il comporte la formation de l'électrode inférieure de la diode (8) PIN ou NIP par implantation ionique du premier film semi-conducteur (2) dans la troisième portion (C).

4. Procédé de fabrication selon l'une quelconque des revendications 1 à 3, **caractérisé en ce que** l'interface entre la couche de conversion (9) et le troisième matériau semi-conducteur (4) est dans le même plan que la face latérale de la couche électriquement isolante (3).

5. Procédé de fabrication selon l'une quelconque des revendications 1 à 4, dans lequel la diode (8) PIN ou NIP est formée par un empilement de couches monocristallines à base de silicium et dans lequel le premier film semi-conducteur (2) est monocristallin.

6. Procédé de fabrication selon la revendication 5, **caractérisé en ce que** la couche de conversion (9) est en germanium.

7. Procédé de fabrication selon l'une des revendications 1 à 6, **caractérisé en ce que** la couche de conversion (9) comporte une partie avec la même structure cristalline que le premier film semi-conducteur (2) et une partie avec la même structure cristalline que le deuxième film semi-conducteur (4).

## Patentansprüche

1. Verfahren zur Herstellung eines Photodetektors, welches folgende Verfahrensschritte umfasst:
- Herstellen eines Substrats (1) mit:
o einem ersten Abschnitt (A), der aufeinanderfolgend einen ersten Halbleiter-Film (2), eine elektrisch isolierende Schicht (3), einen zweiten Halbleiter-Film (4), der dazu vorgesehen ist, einen Wellenleiter zu bilden, und eine Schutzschicht (5) aufweist,
o einem zweiten Abschnitt (B), der aufeinanderfolgend den ersten Halbleiter-Film (2), die elektrisch isolierende Schicht (3), die Schutzschicht (5) aufweist, nicht aber den zweiten Halbleiter-Film (4),
o einem dritten Abschnitt (C), der den ersten Halbleiter-Film (2) aufweist, nicht aber den zweiten Halbleiter-Film (4) und die Schutzschicht (5), wobei der dritte Abschnitt (C) zwischen dem ersten und dem zweiten Abschnitt (A, B) angeordnet ist,
- teilweises Gravieren des zweiten Halbleiter-Films (4) im ersten Abschnitt (A), um einen Hohlraum zu bilden, der von der Schutzschicht (5) und der elektrisch isolierenden Schicht (3) umgrenzt wird,
- Auftragen mindestens eines dritten Halbleiter-Materials (7) in dem dritten Abschnitt (C) dergestalt, dass dort auf dem ersten Halbleiter-Film (2) eine Diode (8) des Typs PIN oder NIP gebildet wird, und Füllen des Hohlraums im ersten Abschnitt (A), um den Wellenleiter zu verlängern,
- Auftragen einer Umwandlungsschicht (9), die in Kontakt mit dem Wellenleiter ist und dazu konfiguriert ist, ein Lichtsignal aufzunehmen, das von dem zweiten Halbleiter-Film (4) kommt, und das Lichtsignal in ein elektrisches Signal umzuwandeln, wobei die Umwandlungsschicht (9) elektrisch mit der Diode (8) des Typs PIN oder NIP verbunden ist, um einen Aufbau des Typs PIPIN oder NINIP zu bilden.

2. Herstellungsverfahren nach Anspruch 1,
**dadurch gekennzeichnet,**
**dass** die Grenzfläche zwischen der Umwandlungsschicht (9) und der oberen Elektrode der PIN- oder NIP-Diode (8) sich in der gleichen Ebene befindet wie die Grenzfläche zwischen der elektrisch isolierenden Schicht (3) und dem zweiten Halbleiter-Film (4).

3. Herstellungsverfahren nach einem der Ansprüche 1 und 2,
**dadurch gekennzeichnet,**
**dass** es die Bildung der unteren Elektrode der PIN- oder NIP-Diode (8) durch Ionenimplantation des ersten Halbleiter-Films (2) im dritten Abschnitt (C) umfasst.

4. Herstellungsverfahren nach einem der Ansprüche 1 bis 3,
**dadurch gekennzeichnet,**
**dass** die Grenzfläche zwischen der Umwandlungsschicht (9) und dem dritten Halbleiter-Material (4) sich in der gleichen Ebene befindet wie die Seitenfläche der elektrisch isolierenden Schicht (3).

5. Herstellungsverfahren nach einem der Ansprüche 1 bis 4, wobei die PIN- oder NIP-Diode (8) durch Aufeinanderstapeln monokristalliner Schichten auf Siliziumbasis gebildet wird und wobei der erste Halbleiter-Film (2) monokristallin ist.

6. Herstellungsverfahren nach Anspruch 5,
**dadurch gekennzeichnet,**
**dass** die Umwandlungsschicht (9) aus Germanium besteht.

7. Herstellungsverfahren nach einem der Ansprüche 1 bis 6,
**dadurch gekennzeichnet,**
**dass** die Umwandlungsschicht (9) einen Teil mit der gleichen kristallinen Struktur wie die des ersten Halbleiter-Films (2) und einen Teil mit der gleichen kristallinen Struktur wie die des zweiten Halbleiter-Films (4) aufweist.

## Claims

1. A method for fabricating a photodetector, comprising the following steps:
- providing a substrate (1) comprising:
o a first portion (A) successively provided with a first semiconductor film (2), an electrically insulating layer (3), a second semiconductor film (4) designed to form a waveguide, and a protection layer (5),
o a second portion (B) successively provided with the first semiconductor film (2), the electrically insulating layer (3), and the protection layer (5) and devoid of the second semiconductor film (4),
o a third portion (C) provided with the first semiconductor film (2), and devoid of the second semiconductor film (4) and the protection layer (5), the third portion (C) being arranged between the first and second portions (A, B),
- partially etching the second semiconductor film (4) in the first portion (A) to form a cavity delineated by the protection layer (5) and the electrically insulating layer (3),
- depositing at least a third semiconductor material (7) so as to form a diode (8) of PIN or NIP type in the third portion (C) from the first semiconductor film (2) and to fill the cavity of the first portion to prolong the waveguide,
- depositing a conversion layer (9) in contact with the waveguide and configured to absorb a light signal coming from the second semiconductor film (4) and to convert the light signal into an electric signal, the conversion layer (9) electrically connecting the PIN or NIP diode (8) to form a structure of PIPIN or NINIP type.

2. The method for fabricating according to claim 1, **characterized in that** the interface between the conversion layer (9) and the top electrode of the PIN or NIP diode (8) is in the same plane as the interface between the electrically insulating layer (3) and the second semiconductor film (4).

3. The method for fabricating according to one of claims 1 and 2, **characterized in that** it comprises formation of the bottom electrode of the PIN or NIP diode (8) by ion implantation of the first semiconductor film (2) in the third portion (C).

4. The method for fabricating according to any one of claims 1 to 3, **characterized in that** the interface between the conversion layer (9) and the third semiconductor material (4) is in the same plane as the lateral surfaces of the electrically insulating layer (3).

5. The method for fabricating according to any one of claims 1 to 4, wherein the PIN or NIP diode (8) is formed by a stack of silicon-based monocrystalline layers and wherein the first semiconductor film (2) is monocrystalline.

6. The method for fabricating according to claim 5, **characterized in that** the conversion layer (9) is made from germanium.

7. The method for fabricating according to one of claims 1 to 6, **characterized in that** the conversion layer (9) comprises a part with the same crystalline structure as the first semiconductor film (2) and a part with the same crystalline structure as the second semiconductor film (4).
